# EUROPEAN PATENT APPLICATION

(11) **EP 2 662 902 A1**
(43) Date of publication of application: **13.11.2013**
(21) Application number: 13166633.1
(22) Date of filing: 06.05.2013
(51) Int. Cl.: H01L 31/05, H01L 31/068, H01L 31/18, H05K 1/09

(54) **Solar cell module and fabrication method of the same**

(30) Priority: 08.05.2012 KR 20120048794
(71) Applicant: LSIS Co., Ltd., Dongan-gu, Anyang-si Gyeonggi-do 431-848 (KR)
(72) Inventor: Kim, Kwang Wook, Gyeonggi-do (KR)
(74) Representative: Johansson, Magnus

(57) **Abstract**

A method for fabricating a solar cell module comprises: dispersing carbon nanotubes into a soldering flux; spraying the soldering flux including the carbon nanotubes, onto connection parts between solar cell devices and an interconnector; and connecting the solar cell devices with the interconnector using the soldering flux.

## Description

### BACKGROUND OF THE INVENTION

### 1. Field of the Invention

The present invention relates to a solar cell module, and particularly, to a crystalline silicon solar cell module and a fabrication method of the same.

### 2. Background of the Invention

The conventional method for fabricating a crystalline silicon solar cell module comprises serially connecting silicon solar cell devices (i.e., unitary devices) with each other; sequentially laminating a glass, an encapsulant, a solar cell device, an encapsulant and a rear protective sheet, and then molding the assembly at a high temperature; and attaching a junction box, an external terminal to the assembly.

In the step of serially connecting silicon solar cell devices with each other, solar cell devices and a ribbon come in contact with each other, and then the solar cell devices and the ribbon are heated at a high temperature for soldering.

More specifically, a ribbon wire plated with lead or tin is connected onto solar cells by soldering. Here, the solar cells have output loss of about 5% when compared with a cell efficiency after being fabricated into a module.

Accordingly, it is required to propose a method for enhancing an output efficiency of a solar cell module by reducing a resistance occurring when a ribbon is connected to solar cell devices, and by enhancing conductivity between the solar cell devices and the ribbon.

### SUMMARY OF THE INVENTION

Therefore, an aspect of the detailed description is to provide a method capable of reducing a resistance occurring when a ribbon is connected to solar cell devices.

Another aspect of the detailed description is to provide a method capable of enhancing conductivity between solar cell devices and a ribbon.

Still another aspect of the detailed description is to provide a method capable of enhancing an output efficiency of a solar cell module.

To achieve these and other advantages and in accordance with the purpose of this specification, as embodied and broadly described herein, there is provided a method for fabricating a solar cell module, comprising: dispersing carbon nanotubes into a soldering flux; spraying the soldering flux including the carbon nanotubes, onto connection parts between solar cell devices and an interconnector; and connecting the solar cell devices with the interconnector using the soldering flux.

According to another aspect of the present invention, the carbon nanotubes may comprise at least one of single-walled carbon nanotubes, double-walled carbon nanotubes, multi-walled carbon nanotubes, and nanotube ropes.

According to another aspect of the present invention, the carbon nanotubes may have at least one of an arm chair structure and a zigzag structure.

According to another aspect of the present invention, the interconnector may comprise a ribbon wire.

To achieve these and other advantages and in accordance with the purpose of this specification, as embodied and broadly described herein, there is also provided a solar cell module, comprising: a plurality of solar cell devices; an interconnector configured to connect the solar cell devices to each other; and a soldering flux configured to connect the solar cell devices with the interconnector, wherein the soldering flux comprises carbon nanotubes.

According to another aspect of the present invention, the carbon nanotubes may comprise at least one of single-walled carbon nanotubes, double-walled carbon nanotubes, multi-walled carbon nanotubes, and nanotube ropes.

According to another aspect of the present invention, the carbon nanotubes may comprise at least one of an arm chair structure and a zigzag structure.

According to another aspect of the present invention, the interconnector may comprise a ribbon wire.

The present invention can have the following advantages.

Firstly, a resistance, which occurs when the ribbon is connected to the solar cell devices, can be reduced.

Secondly, conductivity between the solar cell devices and the ribbon can be enhanced.

Thirdly, an output efficiency of the solar cell module can be enhanced.

Further scope of applicability of the present application will become more apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from the detailed description.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a flowchart showing a method for fabricating a solar cell module according to an embodiment of the present invention;
FIGs. 2A and 2B are views showing a method for dispersing carbon nanotubes into a soldering flux according to an embodiment of the present invention;
FIG. 3 is a view showing a method for spraying a soldering flux onto connection parts between solar cell devices and an interconnector, and a method for connecting the solar cell devices with the interconnector;
FIGs. 4A and 4B are views showing another example to connect solar cell devices with an interconnector;
FIG. 5 is a view showing a silicon solar cell module fabricated according to an embodiment of the present invention; and
FIGs. 6A and 6B are views showing an example to perform a photovoltaic power generation using a silicon solar cell module.

### DETAILED DESCRIPTION OF THE INVENTION

Various modifications and embodiments can be made in the present invention, and reference will be made in detail to the preferred embodiments of the present invention, examples of which are illustrated in the accompanying drawings. However, it should also be understood that embodiments are not limited by any of the details of the foregoing description, but rather should be construed broadly within its spirit and scope and it is intended that the present invention cover modifications and variations of this invention provided they come within the scope of the appended claims and their equivalents.

A singular expression includes a plural concept unless there is a contextually distinctive difference therebetween. In the present invention, a term of "include" or "have" should not be interpreted as if it absolutely includes a plurality of components or steps of the specification. Rather, the term of "include" or "have" may not include some components or some steps, or may further include additional components.

The suffixes attached to components of the separate type safety injection tank, such as 'module', 'unit' and 'portion' were used for facilitation of the detailed description of the present invention. Therefore, the suffixes do not have different meanings from each other.

Though terms of 'first', 'second', etc. are used to explain various components, the components are not limited to the terms. The terms are used only to distinguish one component from another component. For example, a first component may be referred to as a second component, or similarly, the second component may be referred to as the first component within the scope of the present invention.

Description will now be given in detail of the exemplary embodiments, with reference to the accompanying drawings. For the sake of brief description with reference to the drawings, the same or equivalent components will be provided with the same reference numbers, and description thereof will not be repeated.

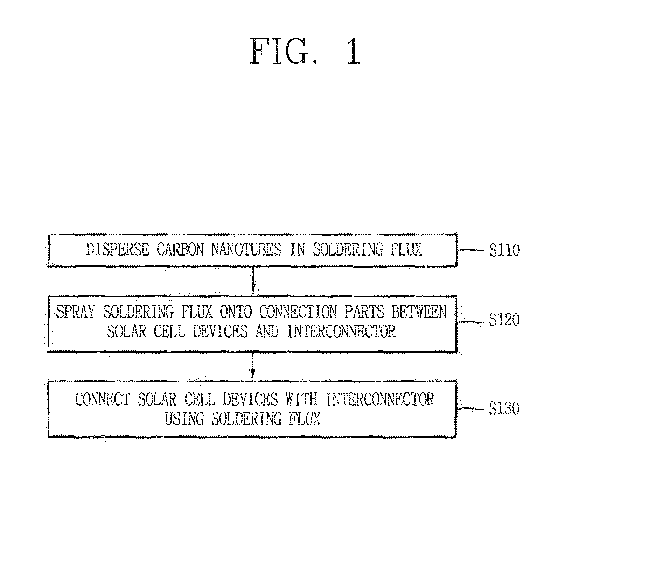

FIG. 1 is a flowchart showing a method for fabricating a solar cell module according to an embodiment of the present invention.

The method for fabricating a solar cell module according to an embodiment of the present invention may comprise dispersing a carbon nanotube into a soldering flux (S110).

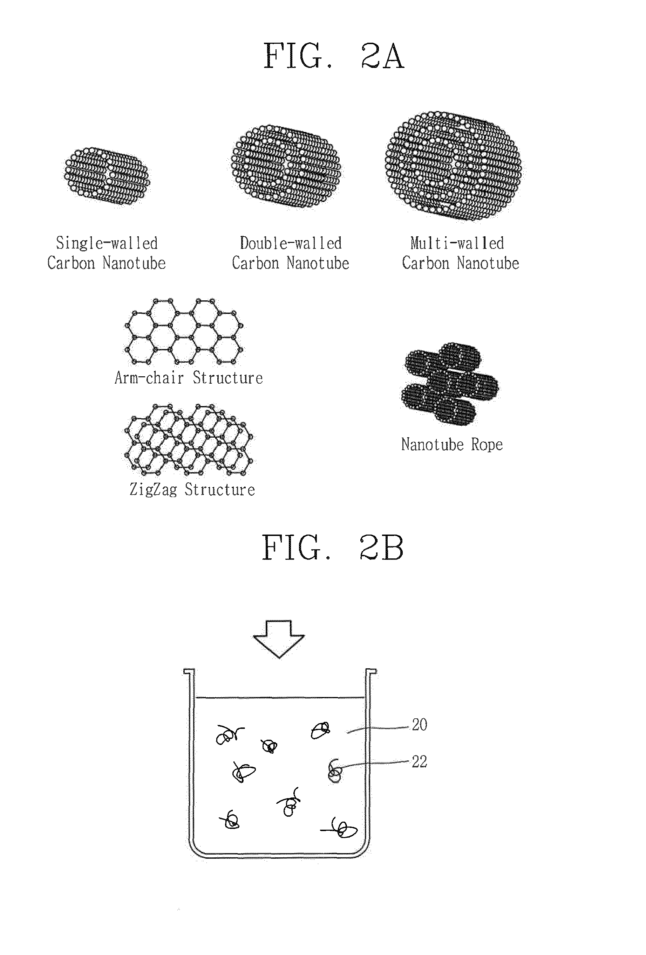

FIGs. 2A and 2B are views showing a method for dispersing carbon nanotubes into a soldering flux according to an embodiment of the present invention.

As shown in FIG. 2B, carbon nanotubes 22 may be evenly dispersed into a soldering flux 20.

Referring to FIG. 2A, the carbon nanotubes 22 may comprise single-walled carbon nanotubes, double-walled carbon nanotubes, multi-walled carbon nanotubes, and nanotube ropes. In this case, the carbon nanotubes are classified according to a bond number.

The carbon nanotubes may have at least one of an arm chair structure and a zigzag structure. In this case, the carbon nanotubes are classified according to an arrangement shape of atoms.

The soldering flux, into which the carbon nanotubes have been dispersed, has very high conductivity.

The method for fabricating a solar cell module according to an embodiment of the present invention may comprise spraying the soldering flux including the carbon nanotubes, onto connection parts between solar cell devices and an interconnector (S120). Also, the method for fabricating a solar cell module according to an embodiment of the present invention may comprise connecting the solar cell devices with the interconnector using the soldering flux (S130).

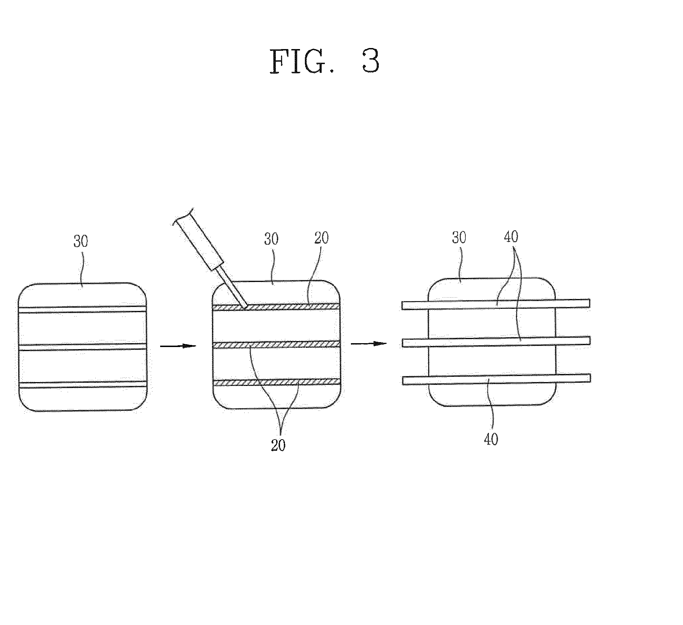

FIG. 3 is a view showing a method for spraying the soldering flux onto connection parts between the solar cell devices and the interconnector, and a method for connecting the solar cell devices with the interconnector.

Referring to FIG. 3, the position of the solar cell devices 30 may be fixed so that the solar cell devices 30 can be connected to each other in series. The soldering flux 20 including the carbon nanotubes may be evenly sprayed onto connection parts between the solar cell devices and an interconnector 40 (ribbon connection parts). Then, the interconnector 40 is aligned on the positions where the soldering flux 20 has been sprayed, so that the solar cell devices 30 and the interconnector 40 are connected to each other by the soldering flux 20. In this case, an output of the solar cell module may be enhanced, because a contact resistance is lowered.

The interconnector 40 may be implemented as a ribbon wire used in the solar cell module.

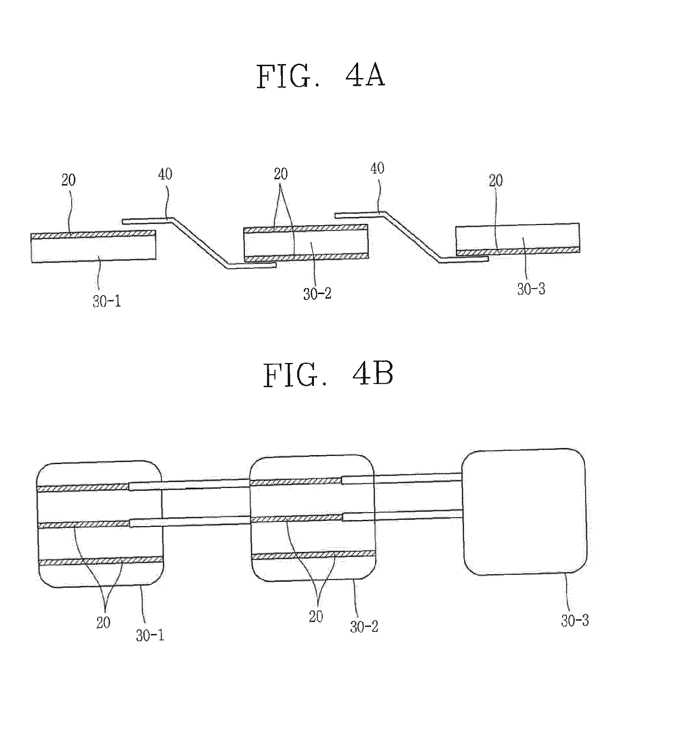

FIGs. 4A and 4B are views showing another example to connect the solar cell devices with the interconnector.

FIG. 4A shows a side surface of the solar cell devices and the interconnector connected to each other. FIG. 4B illustrates an upper surface of FIG. 4A.

Referring to FIGs. 4A and 4B, in a case where solar cell devices 30-1, 30-2 and 30-3 are connected to each other in series, an upper surface of the solar cell device 30-1 may be serially connected to a lower surface of the solar cell device 30-2, by the interconnector 40. Further, an upper surface of the solar cell device 30-2 may be serially connected to a lower surface of the solar cell device 30-3, by the interconnector 40. In this case, flux may be sprayed onto positions of the solar cell devices contacting the interconnector. Alternatively, flux may be sprayed onto positions of the interconnector contacting the solar cell devices.

The present invention may be applied to a similar structure to the conventional structure for fabricating a solar cell module. Further, as various types of carbon nanotubes are applied to flux, can be reduced a resistance occurring when the ribbon is connected to the solar cell devices.

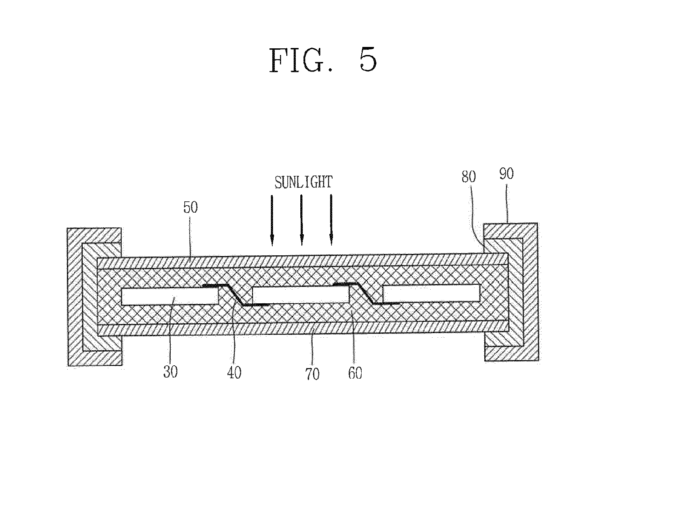

FIG. 5 is a view showing a silicon solar cell module fabricated according to an embodiment of the present invention.

The silicon solar cell module may comprise a surface material 50, a filling material (ethylene vinyl acetate, EVA) 60, solar cell devices 30, a filling material (ethylene vinyl acetate, EVA) 60, a back sheet surface material 70.

The surface material 50 may be implemented as a low iron reinforcing glass, etc. Preferably, the surface material is formed to have high transmittance, and is processed to have low optical return loss.

The EVA serving as the filling material 60 is inserted into a space between a front surface of the solar cell devices 30 and the surface material 50, and a space between a rear surface of the solar cell devices 30 and the surface material 70, in order to protect the brittle solar cell devices. When exposed to ultraviolet rays for a long time, the EVA sheet may discolor and may have its damp proof property lowered. Accordingly, it is important to adopt processes appropriate to characteristics of the EVS sheet when fabricating the solar cell module, so that the solar cell module can have a prolonged lifespan and an enhanced reliability.

The back sheet surface material 70 is positioned on a rear surface of the solar cell module, and should be configured to be simply treated and to have an excellent bonding force between layers. Further, the back sheet surface material 70 should be configured to protect the solar cell module from external environments, by preventing moisture from being introduced into the solar cell module from the rear surface of the solar cell module.

The solar cell devices 30 may be connected to each other by an interconnector. The interconnector may be implemented as a metallic ribbon.

The solar cell module may comprise a sealant 80 such as a butyl rubber, and an external cover 90 formed of aluminum, etc.

An output amount of the solar cell module may be determined according to a current amount and a voltage. The current amount may be proportional to an area of silicon solar cell devices, unitary devices. The voltage may be increased as the solar cell devices are connected with each other in series.

In the present invention, the solar cell devices and the metallic ribbon are connected to each other by the soldering flux into which the carbon nanotubes of high conductivity have been dispersed. This can enhance conductivity between the solar cell devices and the metallic ribbon. As a result, an output of the solar cell module can be enhanced.

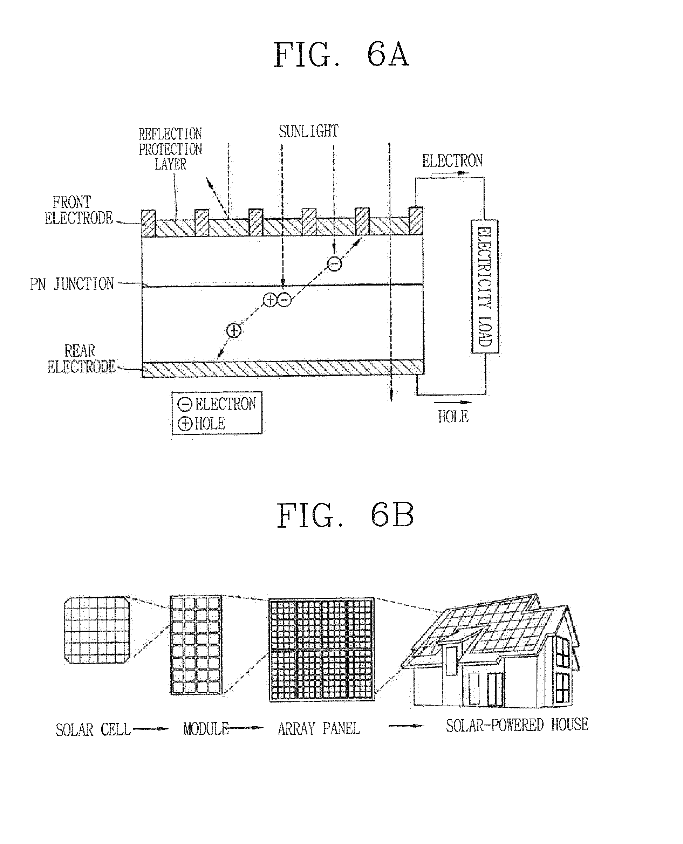

FIGs. 6A and 6B are views showing an example to perform a photovoltaic power generation using a silicon solar cell module.

The photovoltaic power generation indicates a method for generating power by directly converting sunlight into electricity.

Referring to FIG. 6A, once sunlight of energy larger than band-gap energy of a semiconductor is incident onto solar cells formed of a semiconductor by a p-n junction, pairs of electrons and holes are generated. As the electrons are collected into an 'n'-type layer and the holes are collected into a 'p'-type layer, a photoelectromotive force (photovoltage) is generated between the 'p'-type layer and the 'n'-type layer. In this state, if a load is applied to a front electrode and a rear electrode, current flows.

Referring to FIG. 6B, such solar cells are connected to each other in series or in parallel, to have a structure capable of enduring natural environments and external impacts for a long time. The minimum unit of the solar cells is called a 'photovoltaic module'. The photovoltaic modules may be disposed in the form of a photovoltaic array according to a substantially-used load. The array panels may be installed on a solar-powered house, etc.

The aforementioned embodiments may be implemented individually or in a combined manner. Further, steps in one embodiment may be implemented individually, or in a combined manner with steps in another embodiment.

Various embodiments described herein may be implemented in a computer-readable medium using, for example, software, hardware, or some combination thereof.

For a hardware implementation, the embodiments described herein may be implemented within one or more of Application Specific Integrated Circuits (ASICs), Digital Signal Processors (DSPs), Digital Signal Processing Devices (DSPDs), Programmable Logic Devices (PLDs), Field Programmable Gate Arrays (FPGAs), processors, controllers, micro-controllers, micro processors, other electronic units designed to perform the functions described herein, or a selective combination thereof. In some cases, such embodiments are implemented by the controller 180.

For software implementation, the embodiments such as procedures and functions may be implemented together with separate software modules each of which performs at least one of functions and operations. The software codes can be implemented with a software application written in any suitable programming language. Also, the software codes may be stored in a memory and executed by a processor.

The present invention can have the following advantages.

Firstly, a resistance, which occurs when the ribbon is connected to the solar cell devices, can be reduced.

Secondly, conductivity between the solar cell devices and the ribbon can be enhanced.

Thirdly, an output efficiency of the solar cell module can be enhanced.

The foregoing embodiments and advantages are merely exemplary and are not to be considered as limiting the present invention. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A method for fabricating a solar cell module, comprising:
dispersing carbon nanotubes into a soldering flux 20;
spraying the soldering flux 20 including the carbon nanotubes, onto connection parts between solar cell devices 30 and an interconnector 40; and
connecting the solar cell devices 30 with the interconnector 40 using the soldering flux 20.

2. The method of claim 1, wherein the carbon nanotubes comprise at least one of single-walled carbon nanotubes, double-walled carbon nanotubes, multi-walled carbon nanotubes, and nanotube ropes.

3. The method of any of claims 1 to 2, wherein the carbon nanotubes have at least one of an arm chair structure and a zigzag structure.

4. The method of any of claims 1 to 3, wherein the interconnector 40 comprises a ribbon wire.

5. A solar cell module, comprising:
a plurality of solar cell devices 30;
an interconnector 40 configured to connect the solar cell devices 30 to each other; and
a soldering flux 20 configured to connect the solar cell devices 30 with the interconnector 40,
wherein the soldering flux 20 comprises carbon nanotubes.
